# EUROPEAN PATENT APPLICATION

(11) **EP 0 752 809 A1**
(43) Date of publication of application: **08.01.1997**
(21) Application number: 95304647.1
(22) Date of filing: 03.07.1995
(51) Int. Cl.: H05K 7/14, H05K 5/00, H05K 5/04

(54) **Enclosure for a printed circuit board**

(71) Applicant: WARNER ELECTRIC S.A., CH-1029 Villars Ste Croix (CH)
(72) Inventor: Gérard, Pascal, F-01220 Divonne (FR); Szabo, Jorg, CH-1024 Ecublens (CH)
(74) Representative: Cheyne, John Robert Alexander Mackenzie

(57) **Abstract**

An improved structure for an enclosure for a printed circuit board 50 includes first and second parts 12, 14 which fit together to form the enclosure. Preferably, the first and second parts 12, 14 each include an end portion 16, 36 and a side portion 18, 38. Each of the first and second parts 12, 14 further includes an inwardly extending detent 26 and a connecting slot 40 adapted to receive the detent to releasably connect the first part 12 to the second part 14. The enclosure includes a printed circuit board holder which preferably includes a pair of flanges 20 formed integrally with each of the side protions 18. The flanges 20 extend longitudinally along the upper and lower edges of the side protions 18, and extend perpendicular to the side portions 18 and parallel to one another. The longitudinal ends of each of the upper flanges 20 are bent downwardly, and the longitudinal ends of each of the lower flanges 20 are bent upwardly. A slot 22 is formed through each of the longitudinal ends of the flanges 20. The printed circuit board 50 is held securely in the slots 22, and positioned between the upper and lower flanges 20.

## Description

### BACKGROUND OF THE INVENTION

This invention relates in general to printed circuit boards and in particular to an improved structure for an enclosure for such a printed circuit board.

Printed circuit boards are well known devices which are often used in electrical or electronic devices. A typical printed circuit board includes a flat rigid board formed from an electrical non-conductive material. A plurality of electrical circuit components are mounted on the board and are connected together by electrical conductors. In some instances, the electrical conductors are embodied as conventional metallic wires, the ends of which are secured to the board. More often, however, the electrical conductors are embodied as thin layers of a metallic material which are deposited or "printed" on the surface of the board, Printed circuit boards facilitate the arrangement and connection of the electrical circuit components in a safe and efficient manner.

It is known to provide enclosures to support printed circuit boards for use and to protect them from dust, moisture, and physical contact. Such enclosures are usually formed from a rigid material, such as a metallic material. A typical enclosure for a printed circuit board consists of many parts. For example, one type of conventional enclosure includes six plates which compose the sides of a rectangular box. A printed circuit board is secured inside the enclosure by sliding it between two of the opposed plates. Eight threaded fasteners are required to hold together all the parts. Other known enclosures are similarly composed of a relatively large number of individual parts.

The structures of conventional enclosures suffer from several disadvantages. A first disadvantage is that a large number of parts are required to construct the enclosure, which results in higher costs for purchasing, manufacturing, and inventory. A second disadvantage is that the large number of parts increases the complexity and cost to assemble the enclosure, and further to disassemble the enclosure when it is necessary to gain access to the printed circuit board enclosed therein. A third disadvantage is that conventional enclosures are not readily adjustable for use with printed circuit boards of differing sizes. A fourth disadvantage is that a conventional enclosure must be relatively large in size to contain all of the mounting components therein, which increases the cost thereof and, in some instances, limits the locations wherein the enclosure can be mounted during use. Accordingly, it would be desirable to provide an improved structure for an enclosure for a printed circuit board which avoids all of these disadvantages.

### SUMMARY OF THE INVENTION

This invention relates to an improved structure for an enclosure for a printed circuit board. The enclosure includes first and second parts which fit together to form the enclosure. Preferably the first and second parts each include an end portion and a side portion. Each of the first and second parts further includes an inwardly extending detent and a connecting slot adapted to receive the detent to releasably connect the first part to the second part. The enclosure includes a printed circuit board holder which preferably includes a pair of flanges formed integrally with each of the side portions. The flanges extend longitudinally along the upper and lower edges of the side portions, and extend perpendicular to the side portions and parallel to one another. The longitudinal ends of each of the upper flanges are bent downwardly, and the longitudinal ends of each of the lower flanges are bent upwardly. A slot is formed through each of the longitudinal ends of the flanges. The printed circuit board is held securely in the slots and positioned between the upper and lower flanges. The enclosure is constructed of only two parts so it is inexpensive and easy to manufacture and assemble, Because the two parts are releasably connected by a detent and connecting slot, threaded fasteners are not required to hold the enclosure together. The enclosure can be easily manufactured in any desired size to exactly fit a printed circuit board.

Various objects and advantages of this invention will become apparent to those skilled in the art from the following detailed description of the preferred embodiments, when read in light of the accompanying drawings.

### BRIEF DESCRIPTION OF THE DRAWINGS

Fig. 1 is an exploded perspective view of a first embodiment of an improved structure for an enclosure for a printed circuit board in accordance with this invention.

Fig. 2 is a perspective view of a printed circuit board adapted to be protectively enclosed within the enclosure illustrated in Fig. 1.

Fig. 3 is an exploded perspective view of the printed circuit board illustrated in Fig. 2 mounted within one of the parts of the enclosure illustrated in Fig. 1.

Fig. 4 is a perspective view of the printed circuit board enclosure illustrated in Figs. 1 through 3 shown assembled.

Fig. 5 is an exploded perspective view of a second embodiment of an improved structure for an enclosure for a printed circuit board in accordance with this invention.

Fig. 6 is a perspective view of the printed circuit board enclosure illustrated in Fig. 5 shown assembled.

Fig. 7 is an exploded perspective view of a third embodiment of an improved structure for an enclosure for a printed circuit board in accordance with this invention.

Fig. 8 is a perspective view of the printed circuit board enclosure illustrated in Fig. 7 shown assembled.

### DETAILED DESCRIPTION OF THE PREFERRED EMBODIMENTS

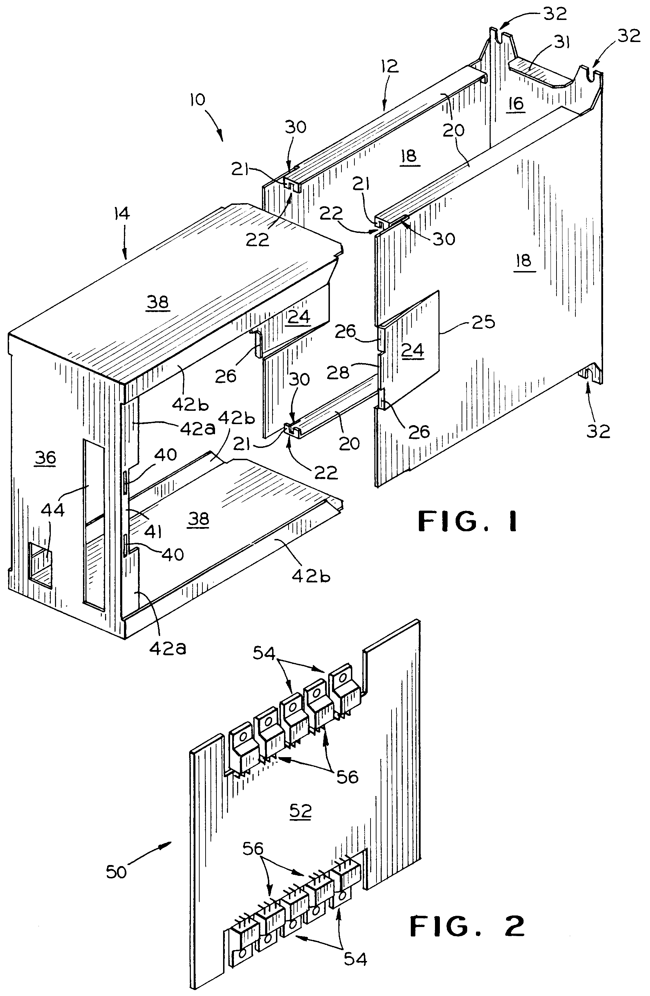

Referring now to the drawings, there is illustrated in Figs. 1 through 4 a first embodiment of an enclosure, indicated generally at 10, for a printed circuit board 50 in accordance with this invention. The enclosure 10 includes a first part, indicated generally at 12, and a second part indicated generally at 14. The first part 12 includes an end portion 16 and two side portions 18. The side portions 18 extend parallel to one another and perpendicular to the end portion 16. The end portion 16 and side portions 18 are generally flat panels that are rectangular in shape. In the illustrated embodiment, the end portion 16 and the side portions 18 are formed from a single sheet of rigid metallic material which is bent to the desired shape.

Means are provided for supporting the printed circuit board 50 within the enclosure 10. As shown in Fig. 1, a pair of flanges 20 are formed integrally with each of the side portions 18. The flanges 20 extend longitudinally along the upper and lower edges of the side portions 18 and are bent inwardly toward one another. As a result, the flanges 20 extend perpendicular to the side portions 18 and parallel to one another. The longitudinal ends 21 of each of the upper flanges 20 are bent downwardly so as to extend parallel with the end portion 16. Similarly, the longitudinal ends 21 of each of the lower flanges 20 are bent upwardly so as to extend parallel with the end portion 16 and the other longitudinal ends 21. A slot 22 is formed through each of the longitudinal ends 21 of the flanges 20. These structures hold the printed circuit board 50 within the enclosure 10 in a manner which will be discussed below.

The first part 12 of the enclosure 10 has a flexible portion 24 formed in each of the side portions 18. In the illustrated embodiment, the flexible portions 24 are formed in the shape of a flexible strip positioned at the outermost end of each side portion 18. The flexible portion 24 is formed integrally with the side portion 18 but is cut out along its upper and lower sides. Thus the flexible portion 24 can move inwardly and outwardly in the side portion 18 by being bent along a hinge 25. In Fig. 1 the flexible portion 24 is shown in the outward position. At least one, and preferably two, inwardly extending detents 26 are formed on each of the flexible portions 24. Each of the flexible portions 24 further includes a tab 28 which can be grasped to facilitate inward and outward movement of the flexible portion. As will be explained below, moving the flexible portion 24 inwardly connects the first part 12 of the enclosure 10 to the second part 14, and moving the flexible portion outwardly disconnects the two parts.

The first part 12 preferably includes positioning means for positioning the first part 12 against the second part 14 when they are connected to form the enclosure 10, as will be explained below. As shown in Fig. 1, the preferred positioning means in the first part 12 include positioning slots 30 which are formed in each of the four outward corners between the flanges 20 and the side portions 18. The preferred positioning means in the first part 12 also include positioning flanges 31 formed integrally along the upper and lower edges of the end portion 16, and extending perpendicular to the end portion.

The first part 12 also preferably includes mounting means 32 for mounting the enclosure 10 to a wall for use with an electrical circuit. Preferred mounting means include mounting slots 32 positioned at the four comers of the end portion 16 of the first part 12.

The enclosure 10 further includes a second part, indicated generally at 14. The second part 14 includes an end portion 36 and two side portions 38. The side portions 38 extend parallel to one another and perpendicular to the end portion 36. The end portion 36 and side portions 38 are generally flat panels that are rectangular in shape. In the illustrated embodiment, the end portion 36 and the side portions 38 are formed from a single sheet of rigid metallic material which is bent to the desired shape.

The second part 14 includes at least one, and preferably two, connecting slots 40 formed in a flange 41 formed integrally along each of the side edges of the end portion 36. Each of the flanges 41 extends perpendicularly from the end portion 36. The purpose of these connecting slots 40 will be explained below.

The second part 14 also preferably includes positioning means for positioning the first part 12 against the second part 14 when they are connected to form the enclosure 10, as will be explained below. As shown in Fig. 1, the preferred positioning means include positioning flanges 42a formed integrally along both side edges of the end portion 36. The positioning flanges 42a extend perpendicularly from the end portion 36. The second part 14 also preferably include positioning flanges 42b formed integrally along the upper and lower side portions 38 of the second part 14. The positioning flanges 42b extend perpendicular to the side portions 38.

Apertures 44 are formed in the end portion 36 of the second part 14 of the enclosure 10. The apertures 44 provide access to the interior of the enclosure 10 for electrical cords and other electrical connectors and devices.

Referring now to Fig. 2, there is illustrated a printed circuit board, indicated generally at 50. The printed circuit board 50 is conventional in the art and is intended to be representative of any known printed circuit board which can be held within the enclosure 10. The illustrated printed circuit board 50 includes a flat rigid panel 52 upon which a plurality of electrical components 54 is mounted. The electrical components 54 are electrically connected together by a plurality of electrical conductors (not shown) which are typically printed on one or both surfaces of the rigid panel 52. Each of the electrical components 54 is supported on and electrically connected to the rigid panel 52 by one or more electrical leads 56. A plurality of conventional connector devices not shown, can also be provided on the rigid panel 52 to permit the electrical components 54 to be electrically connected to other electrical devices (not shown) located outside of the enclosure 10.

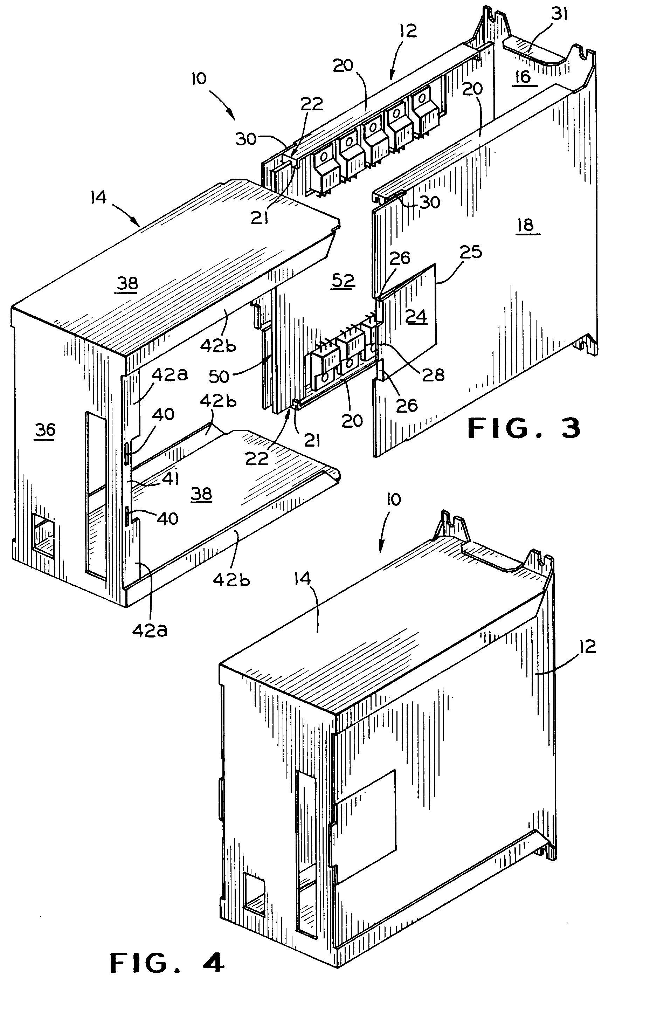

Fig. 3 shows the printed circuit board 50 positioned inside the first part 12 of the enclosure 10. The printed circuit board 50 is held in place by the printed circuit board holder 20. As can be seen in the figure, the edges of the rigid panel 52 of the printed circuit board 50 are held securely in the slots 22 formed in the longitudinal ends 21 of each of the upper and lower flanges 20.

Referring now to Fig. 4 along with Fig. 3, it can be seen how the first part 12 is connected to the second part 14 to form the enclosure 10 of the invention. The first part 12 and second part 14 are aligned with one another as shown in Fig. 3 and then moved together. The flexible portions 24 of the first part 12 are moved outwardly by use of the tabs 28. When the first part 12 and second part 14 are moved together the flexible portions 24 extend over the flanges 41 formed along the end portion 36 of the second part 14. The connecting slots 40 formed in the flanges 41 are adapted to receive the inwardly extending detents 26 formed on the flexible portions 24. The tabs 28 are pressed inwardly to move the detents 26 into the connecting slots 40. In this manner, the first part 12 is releasably connected to the second part 14 to form the enclosure 10. As can be seen in Fig. 4, the preferred enclosure 10 is generally in the shape of a rectangular box.

When the first part 12 is connected to the second part 14, the positioning flanges 42b of the second part 14 abut the side portions 18 of the first part. The positioning flanges 31 of the first part 12 support the side portions 38 of the second part. The positioning flanges 42a of the second part 14 are received in the positioning slots 30 of the first part 12 of the enclosure 10. These positioning means cooperate to correctly position the first part 12 with the second part 14. They provide an additional benefit of helping to maintain the structural integrity of the enclosure 10. For example, when pressure is applied inwardly on the side portions 18 of the first part 12 of the enclosure 10, the positioning flanges 42a hold the side portions 18 in place and prevent them from collapsing inwardly. The positioning flanges 42a and the positioning slots 30 further provide the benefit of preventing the side portions 18 from moving outwardly when the flexible portion 24 is moved outwardly (before the detents 26 are received in the slots 40) during closing of the enclosure 10. The cooperation of the positioning flanges 42a and the positioning slots 30 also provides inward pressure on the flexible portion 24 after it has been moved outwardly so that it closes with a secure click.

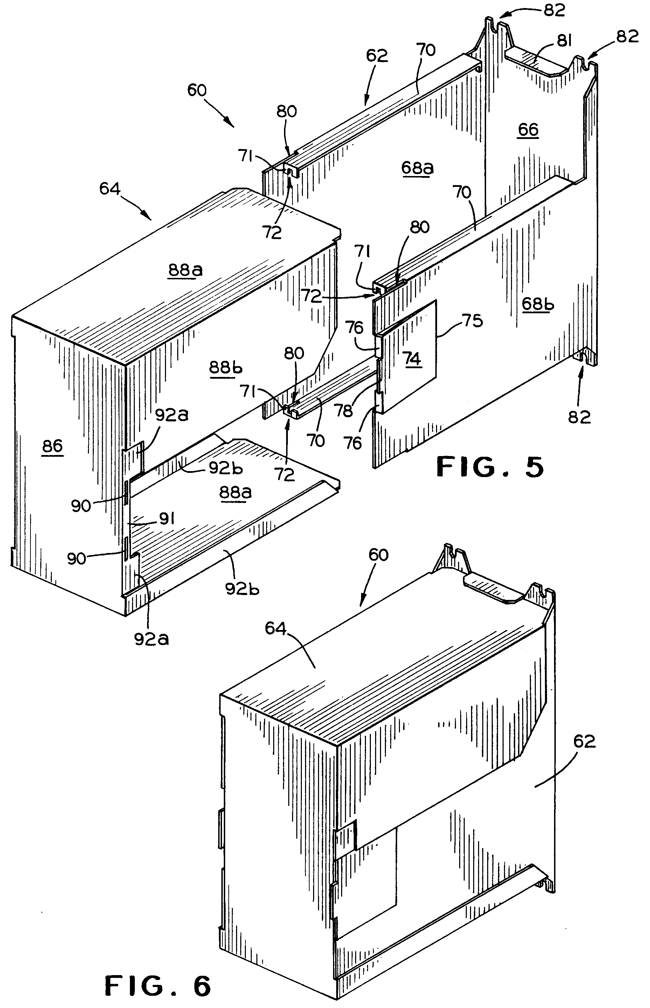

There is illustrated in Figs. 5 and 6 a second embodiment of an enclosure, indicated generally at 60, for a printed circuit board 50 in accordance with this invention. The enclosure 60 includes a first part, indicated generally at 62, and a second part, indicated generally at 64. The first part 62 includes an end portion 66 and two side portions 68. The side portions 68 extend parallel to one another and perpendicular to the end portion 66. The end portion 66 and side portions 68 are generally flat panels that are rectangular in shape. However, unlike the two side portions 18 of the preferred embodiment, the side portions 68 of the second embodiment include a full left side portion 68a and a partial right side portion 68b. In the illustrated embodiment, the end portion 66 and the side portions 68 are formed from a single sheet of rigid metallic material which is bent to the desired shape.

Means are provided for supporting the printed circuit board 50 within the enclosure 60. As shown in Fig. 5, a pair of flanges 70 are formed integrally with each of the side portions 68. The flanges 70 extend longitudinally along the upper and lower edges of the side portions 68 and are bent inwardly toward one another. As a result, the flanges 70 extend perpendicular to the side portions 68 and parallel to one another. The longitudinal ends 71 of each of the upper flanges 70 are bent downwardly so as to extend parallel with the end portion 66. Similarly, the longitudinal ends 71 of each of the lower flanges 70 are bent upwardly to as to extend parallel with the end portion 66 and the other longitudinal ends 71. A slot 72 is formed through each of the longitudinal ends 71 of the flanges 70. These structures hold the printed circuit board 50 within the enclosure 60 in a manner which will be discussed below.

The first part 62 of the enclosure 60 has a flexible portion 74 formed in each of the side portions 68. In the illustrated embodiment, the flexible portions 74 are formed in the shape of a flexible strip positioned at the outermost end of each side portion 68. The flexible portion 74 is formed integrally with the side portion 68 but is cut out along its upper and lower sides. Thus the flexible portion 74 can move inwardly and outwardly in the side portion 68 by being bent along a hinge 75. In Fig. 5 the flexible portion 74 is shown in the outward position. At least one, and preferably two, inwardly extending detents 76 are formed on each of the flexible portions 74. Each of the flexible portions 74 further includes a tab 78 which can be grasped to facilitate inward and outward movement of the flexible portion. As will be explained below moving the flexible portion 74 inwardly connects the first part 62 of the enclosure 60 to the second part 64, and moving the flexible portion outwardly disconnects the two parts.

The first part 62 preferably includes positioning means for positioning the first part 62 against the second part 64 when they are connected to form the enclosure 60, as will be explained below. As shown in Fig. 5, the preferred positioning means m the first part 62 include positioning slots 80 which are formed in each of the four outward corners between the flanges 70 and the side portions 68. The preferred positioning means in the first part 62 also include positioning flanges 81 formed integrally along the upper and lower edges of the end portion 66, and extending perpendicular to the end portion.

The first part 62 also preferably includes mounting means 82 for mounting the enclosure 60 to a wall for use with an electrical circuit. Preferred mounting means include mounting slots 82 positioned at the four corners of the end portion 66 of the first part 62.

The enclosure 60 further includes a second part, indicated generally at 64. The second part 64 includes an end portion 86 and side portions 88 which extend perpendicular to the end portion 86. However, unlike the side portions 38 of the preferred embodiment, the side portions 88 of the second embodiment include full side portions 88a and a partial side portion 88b. The full side portions 88a extend parallel to one another. The partial side portion 88b extends perpendicular to one full side portion 88a and to the end portion 86. The end portion 86 and side portions 88 are generally flat panels that are rectangular in shape. In the illustrated embodiment, the end portion 86 and the side portions 88 are formed from a single sheet of rigid metallic material which is bent to the desired shape.

The second part 64 includes at least one and preferably two, connecting slots 90 formed in a flange 91 formed integrally along each of the side edges of the end portion 86. Each of the flanges 91 extends perpendicularly from the end portion 86. The purpose of these connecting slots 90 will be explained below.

The second part 64 also preferably includes positioning means for positioning the first part 62 against the second part 64 when they are connected to form the enclosure 60 as will be explained below. As shown in Fig. 5, the preferred positioning means include positioning flanges 92a formed integrally along both side edges of the end portion 86. The positioning flanges 92a extend perpendicularly from the end portion 86. The second part 64 also preferably includes positioning flanges 92b formed integrally along both lower side portions 88a and one upper side portion 88a of the second part 64.

The second part 64 of the enclosure 60 can also include apertures (not shown) like in the preferred embodiment to provide access to the interior of the enclosure 60 for electrical cords and other electrical connectors and devices.

Referring now to Fig. 6 along with Fig. 5, it can be seen how the first part 62 is connected to the second part 64 to form the enclosure 60 of the invention. The first part 62 and second part 64 are aligned with one another as shown in Fig. 5 and then moved together. The flexible portions 74 of the first part 62 are moved outwardly by use of the tabs 78. When the first part 62 and second part 64 are moved together, the flexible portions 74 extend over the flanges 91 formed along the end portion 86 of the second part 64. The connecting slots 90 formed in the flanges 91 are adapted to receive the inwardly extending detents 76 formed on the flexible portions 74. The tabs 78 are pressed inwardly to move the detents 76 into the connecting slots 90. In this manner, the first part 62 is releasably connected to the second part 64 to form the enclosure 60. As can be seen in Fig. 6, the preferred enclosure 60 is generally in the shape of a rectangular box. The partial side portion 88b of the second part 64 together with the partial side portion 68b of the first part 62 complete a full side of the enclosure 60.

When the first part 62 is connected to the second part 64, the positioning flanges 92b of the second part 64 abut the side portions 68 of the first part. The positioning flanges 81 of the first part 62 support the side portions 88 of the second part. The positioning flanges 92a of the second part 64 are received in the positioning slots 80 of the first part 62 of the enclosure 60. These positioning means cooperate to correctly position the first part 62 with the second part 64 and help to maintain the structural integrity of the enclosure 60.

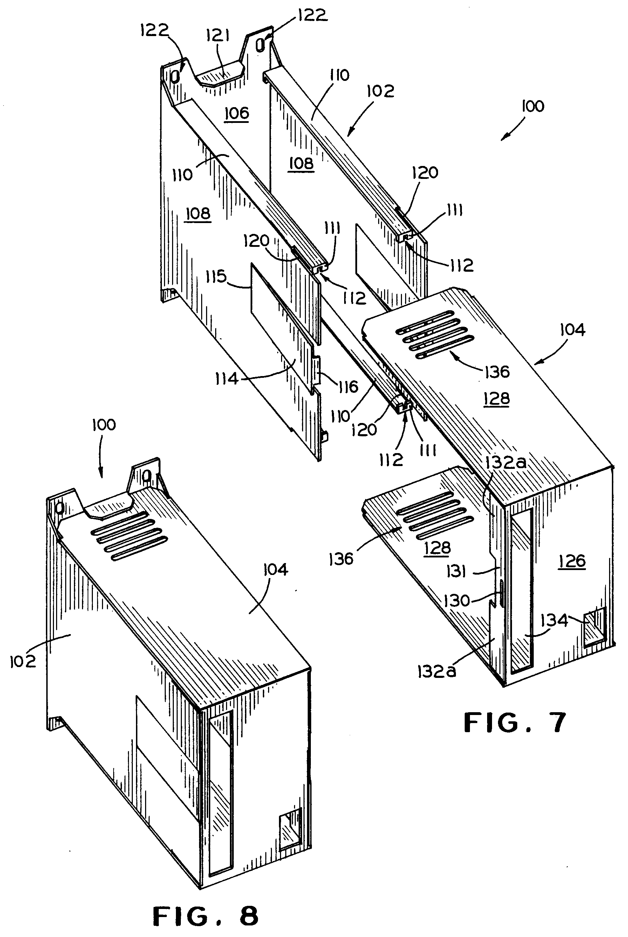

There is illustrated in Figs. 7 and 8 a second embodiment of an enclosure, indicated generally at 100, for a printed circuit board 50 in accordance with this invention. The enclosure 100 includes a first part indicated generally at 102, and a second part, indicated generally at 104. The first part 102 includes an end portion 106 and two side portions 108. The side portions 108 extend parallel to one another and perpendicular to the end portion 106. The end portion 106 and side portions 108 are generally flat panels that are rectangular in shape. In the illustrated embodiment, the end portion 106 and the side portions 108 are formed from a single sheet of rigid metallic material which is bent to the desired shape.

Means are provided for supporting the printed circuit board 50 within the enclosure 100 As shown in Fig. 7, a pair of flanges 110 are formed integrally with each of the side portions 108. The flanges 110 extend longitudinally along the upper and lower edges of the side portions 108 and are bent inwardly toward one another, As a result, the flanges 110 extend perpendicular to the side portions 108 and parallel to one another. The longitudinal ends 111 of each of the upper flanges 110 are bent downwardly so as to extend parallel with the end portion 106. Similarly, the longitudinal ends 111 of each of the lower flanges 110 are bent upwardly to as to extend parallel with the end portion 106 and the other longitudinal ends 111. A slot 112 is formed through each of the longitudinal ends 111 of the flanges 110. These structures hold the printed circuit board 50 within the enclosure 100 in a manner which will be discussed below.

The first part 102 of the enclosure 100 has a flexible portion 114 formed in each of the side portions 108. In the illustrated embodiment, the flexible portions 114 are formed in the shape of a flexible strip positioned at the outermost end of each side portion 108. The flexible portion 114 of this third embodiment is longer and narrower than the flexible portions of the preferred and second embodiments. The flexible portion 114 is formed integrally with the side portion 108 but is cut out along its upper and lower sides. Thus the flexible portion 114 can move inwardly and outwardly in the side portion 108 by being bent along a hinge 115. In Fig. 7 the flexible portion 114 is shown in the outward position. A single inwardly extending detent 116 is formed on each of the flexible portions 114. This differs from the preferred and second embodiments which included two detents formed on each flexible portion. Unlike the preferred and second embodiments, the flexible portions 114 do not include a tab, but the flexible portion can still be moved inwardly and outwardly. As will be explained below, moving the flexible portion 114 inwardly connects the first part 102 of the enclosure 100 to the second part 104, and moving the flexible portion outwardly disconnects the two parts.

The first part 102 preferably includes positioning means for positioning the first part 102 against the second part 104 when they are connected to form the enclosure 100, as will be explained below. As shown in Fig. 7, the preferred positioning means in the first part 102 include positioning slots 120 which are formed in each of the four outward corners between the flanges 110 and the side portions 108. The preferred positioning means in the first part 102 also include positioning flanges 121 formed integrally along the upper and lower edges of the end portion 106, and extending perpendicular to the end portion.

The first part 102 also preferably includes mounting means for mounting the enclosure 100 to a wall for use with an electrical circuit. Preferred mounting means include mounting slots 122 positioned at the four comers of the end portion 106 of the first part 102.

The enclosure 100 further includes a second part, indicated generally at 104. The second part 104 includes an end portion 126 and two side portions 128. The side portions 128 extend parallel to one another and perpendicular to the end portion 126. The end portion 126 and side portions 128 are generally flat panels that are rectangular in shape. In the illustrated embodiment, the end portion 126 and the side portions 128 are formed from a single sheet of rigid metallic material which is bent to the desired shape.

The second part 104 includes a single connecting slots 130 formed in a flange 131 formed integrally along each of the side edges of the end portion 126. This differs from the preferred and second embodiments which included two connecting slots formed in each flange. Each of the flanges 131 extends perpendicularly from the end portion 126. The purpose of these connecting slots 130 will be explained below.

The second part 104 also preferably includes positioning means for positioning the first part 102 against the second pan 104 when they are connected to form the enclosure 100, as will be explained below, As shown in Fig. 7, the preferred positioning means include positioning flanges 132a formed integrally along both side edges of the end portion 126. The positioning flanges 132a extend perpendicularly from the end portion 126. Unlike the preferred and second embodiments, the second part 104 does not include positioning flanges formed integrally along the side portions 128.

Apertures 134 are formed in the end portion 126 of the second part 104 of the enclosure 100. The apertures 134 provide access to the interior of the enclosure 100 for electrical cords and other electrical connectors and devices,

The second part 104 also includes air vents 136 for allowing air circulation in the enclosure 100 to help in cooling the electrical components. The preferred and second embodiments of the invention can also optionally include such air vents.

Referring now to Fig. 8 along with Fig. 7, it can be seen how the first part 102 is connected to the second part 104 to form the enclosure 100 of the invention. The first part 102 and second pan 104 are aligned with one another as shown in Fig. 7 and then moved together. The flexible portions 114 of the first part 102 are moved outwardly. When the first part 102 and second part 104 are moved together, the flexible portions 114 extend over the flanges 131 formed along the end portion 126 of the second part 104 The connecting slots 130 formed in the flanges 131 are adapted to receive the inwardly extending detents 116 formed on the flexible portions 114. The flexible portions 114 are pressed inwardly to move the detents 116 into the connecting slots 130. In this manner, the first part 102 is releasably connected to the second part 104 to form the enclosure 100. As can be seen in Fig 8, the preferred enclosure 100 is generally in the shape of a rectangular box.

When the first part 102 is connected to the second part 104, the positioning flanges 121 of the first part 102 support the side portions 128 of the second part. The positioning flanges 132a of the second part 104 are received in the positioning slots 120 of the first part 102 of the enclosure 100. These positioning means cooperate to correctly position the first part 102 with the second part 104 and help to maintain the structural integrity of the enclosure 100.

Generally speaking, the first pan 12 and second part 14 of the enclosure 10 can be formed having any shape and size so long as they can be releasably connected as described below to form an enclosure 10 which holds a printed circuit board. Any number and configuration of end portions and side portions can be used to form the first part 12 and second part 14. A portion of the enclosure 10 can even be left open and still comprise an enclosure.

The first part 12 and second part 14 of the enclosure 10 can be formed from any suitable material. The preferred material is steel because it is strong and durable and can be readily painted a desired color.

Also, the illustrated means for supporting the printed circuit board 50 within the enclosure 10 included slots 22 formed through the longitudinal ends 21 of the flanges 20. The flanges 20 and longitudinal ends 21 both were formed integrally with each of the side portions 18. However it will be appreciated that other structures may be provided for supporting the printed circuit board 50 within the enclosure 10. Furthermore, any number of such printed circuit board holders can be used within the enclosure 10, positioned at any suitable location therein.

The first part 12 and the second part 14 of the enclosure 10 are releasably connected to each other by means of an inwardly extending detent 26 formed on one of the parts and a connecting slot 40 adapted to receive the detent 26 formed on the other part. The enclosure can also include a plurality of detents and connecting slots, in any combination on the two parts. The detents and connecting slots can be positioned anywhere on the enclosure, so long as the connecting slots receive detents to releasably connect the two parts. If the detents are positioned on a flexible portion 24, any kind of flexible portion can be employed that is suitable for outward and inward movement of the detents

Specific positioning means have been illustrated above for positioning the first part 12 against the second part 14 when they are connected to form the enclosure 10. However the positioning means can be any structures which serve this function, and there can be any number of positioning means located anywhere on the first and second parts.

Additionally, any kind of mounting means can be employed for mounting the enclosure 10 to a wall for use with an electrical circuit.

In accordance with the provisions of the patent statutes, the principle and mode of operation of this invention have been explained and illustrated in its preferred embodiment. However, it must be understood that this invention may be practiced otherwise than as specifically explained and illustrated without departing from its spirit or scope.

## Claims

1. An enclosure for a printed circuit board including first and second parts,
wherein the first and second parts include an inwardly extending detent and a connecting slot adapted to receive the detent to releasably connect the first part to the second part, and
wherein the enclosure includes a printed circuit board holder.

2. The enclosure defined in Claim 1 wherein the first and second parts of the enclosure each include an end portion and a side portion.

3. The enclosure defined in Claim 2 wherein the first and second parts of the enclosure each include an end portion and two parallel side portions extending perpendicularly from the end portion.

4. The enclosure defined in Claim 3 wherein the first part of the enclosure includes an inwardly extending detent on each of its two side portions, and wherein the second part of the enclosure includes two connecting slots on its end portion adapted to receive the two detents

5. The enclosure defined in Claim 4 wherein each detent is positioned on a flexible portion of each side portion, and wherein each flexible portion is movable inwardly to connect and outwardly to disconnect the first and second parts of the enclosure.

6. The enclosure defined in Claim 5 wherein the first part of the enclosure includes a pair of detents on each of its two side portions, and wherein the second part of the enclosure includes a pair of connecting slots on each of the two side edges of its end panel adapted to receive the four detents.

7. The enclosure defined in Claim 3 wherein the printed circuit board holder is formed integrally with a side portion.

8. The enclosure defined in Claim 7 wherein the printed circuit board holder includes a pair of flanges formed integrally with a side portion, wherein said flanges extend longitudinally along the upper and lower edges of said side portion and perpendicularly to said side portion, wherein the longitudinal ends of the upper flange are bent downwardly and the longitudinal ends of the lower flange are bent upwardly, and wherein each longitudinal end includes a slot formed therethrough to hold the printed circuit board.

9. The enclosure defined in Claim 3 wherein the enclosure includes a positioning slot adapted to receive a positioning flange for positioning the first part of the enclosure against the second part of the enclosure.

10. The enclosure defined in Claim 2 wherein one part of the enclosure includes an end portion, a fill side portion and a partial side portion, and
wherein the other part of the enclosure includes an end portion, two full side portions and a partial side portion,
wherein the partial side portions of the two parts of the enclosure together complete a full side of the enclosure.
